**Europäisches Patentamt**

**European Patent Office**

**Office européen des brevets**

(19)

(11) Veröffentlichungsnummer: **0 125 453**

**A2**

(12) # EUROPÄISCHE PATENTANMELDUNG

(21) Anmeldenummer: **84103675.9**

(22) Anmeldetag: **04.04.84**

(51) Int. Cl.³: **H 03 J 7/18**

(30) Priorität: **07.05.83 DE 3316805**

(43) Veröffentlichungstag der Anmeldung:
**21.11.84 Patentblatt 84/47**

(84) Benannte Vertragsstaaten:
**AT CH DE FR GB IT LI NL**

(71) Anmelder: **ROBERT BOSCH GMBH**
**Postfach 50**
**D-7000 Stuttgart 1(DE)**

(72) Erfinder: **Eilers, Norbert, Dipl.-Phys.**
**Seebothstrasse 19**
**D-3200 Hildesheim(DE)**

(54) **Hör- oder Fernsehrundfunksignalempfänger.**

(57) Es wird eine Empfangseinrichtung für Rundfunk- oder Fernsehrundfunksignale vorgeschlagen, die einen automatischen durchstimmbaren Tuner aufweist sowie einen Decoder, mit dem die im Signal enthaltene Programmkennung herausgefiltert werden kann. Weiterhin weist der Empfänger ein Programmtastenfeld auf, bei dem jeder Taste ein bestimmtes Programm fest zugeordnet ist. Den den Tasten zugeordneten Speichern sind Filter vorgeschaltet, so daß in die Speicher nur die Frequenzen solcher Sender ablegbar sind, deren Programmkennung mit einer vorher eingegebenen Programmkennung übereinstimmt. Dadurch ist sichergestellt, daß jeder Taste ein bestimmtes Programm zugeordnet ist.

Fig. 1

EP 0 125 453 A2

R. 19343

28.3.1983 Fd/Le

0125453

ROBERT BOSCH GMBH, 7000 Stuttgart 1

## Hör- oder Fernsehrundfunksignalempfänger

Die Erfindung betrifft einen Hör- oder Fernsehrundfunksignalempfänger nach dem Oberbegriff des Hauptanspruchs.

Die Erfindung geht aus von dem Bedürfnis vieler Fernsehgerätebesitzer, stets dasselbe Programm bei Betätigung bestimmter Tasten empfangen zu können, gleichgültig, wo
sie sich mit ihrem Empfänger aufhalten. Bisher ist bei
einem Ortswechsel des Gerätes eine aufwendige manuelle
Neuprogrammierung erforderlich.

Die Erfindung nutzt die Tatsache aus, daß künftig die Hör-
oder Fernsehrundfunksignale eine Programmkennung enthalten.

Ein Hör- oder Fernsehrundfunksignalempfänger, der im Oberbegriff des Anspruchs 1 näher bezeichneten Art, der erfindungsgemäß entsprechend dem Kennzeichen des Anspruchs 1
ausgebildet ist, löst eine automatische Neuprogrammierung
auf einfache Art.

. . .

0125453

Zeichnung

Anhand von drei Blockschaltbildern wird der Aufbau und die
Wirkungsweise eines Ausführungsbeispiels des neuen, automatisch programmierbaren Hör- oder Fernsehrundfunkempfängers, in dem je jeder Taste ein Programm fest
zugeordnet ist, näher erläutert.

Beschreibung des Ausführungsbeispiels

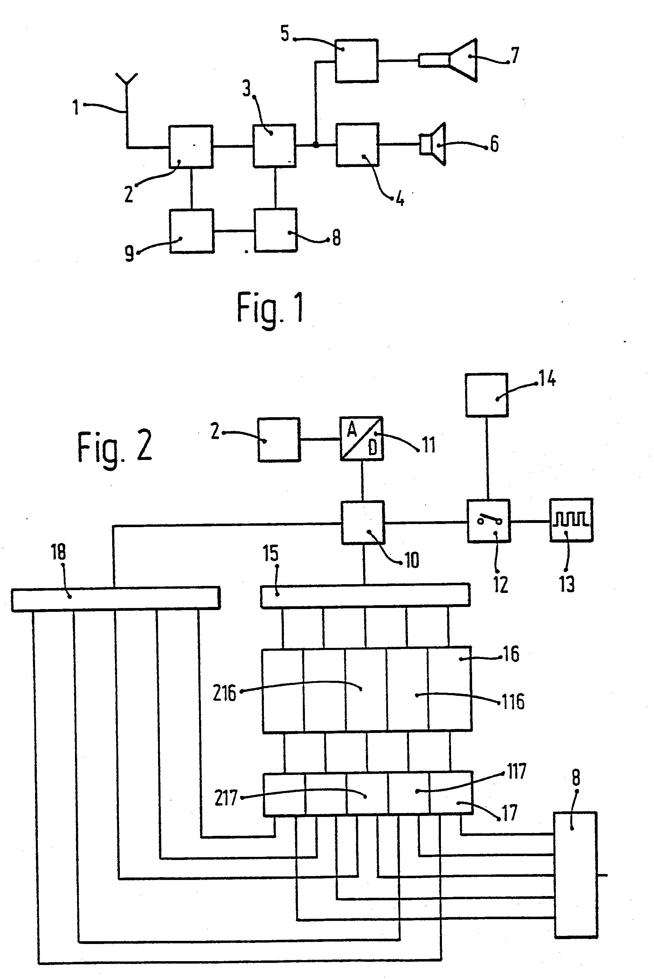

Der Empfänger in Figur 1 enthält einen an die Antenne
1 angeschlossenen Tuner 2, an den die ZF-Stufe 3 mit
dem Demodulator angeschlossen ist. Über nachgeschaltete
Verstärkerstufen 4, 5 wird das demodulierte NF-Signal
dem Lautsprecher 6 oder dem Bildrohr 7 zugeführt. Die
zur Steuerung des letzteren erforderlichen Impulsschaltungen sind nicht näher dargestellt.

An den Demodulator in der ZF-Stufe ist ein Kennungsdecoder 8 angeschlossen, der aus dem empfangenen Signal
die begleitende Programmkennung herausfiltert. Für die
Programmkennung gibt es inzwischen zahlreiche Vorschläge
und Versuchssendungen. Auch die Bereichskennung im Verkehrsfunk kann in gewisser Weise zu diesen gezählt werden.

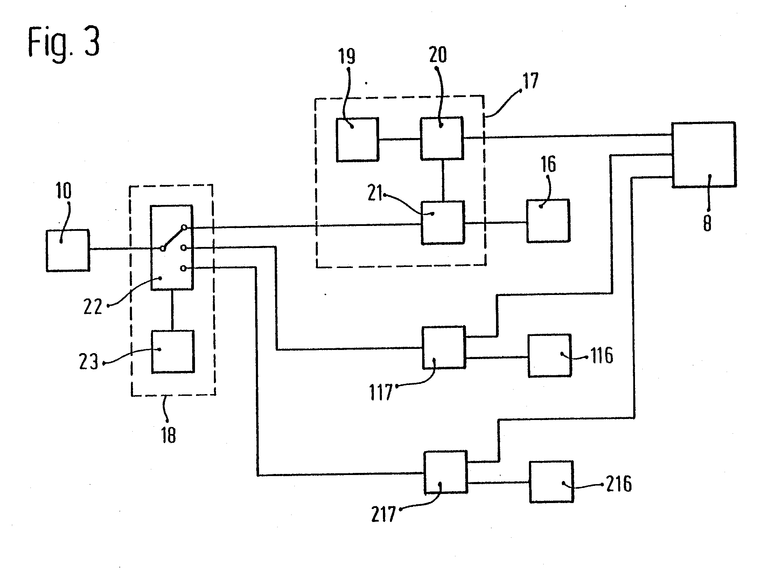

Die Durchstimmung des Tuners 2 kann von einer Suchlaufschaltung 9 aus gesteurt werden, für deren Aufbau es
zahlreiche Beispiele gibt. Die weitere Funktionsbeschreibung geht gemäß Figur 2 und 3 davon aus, daß die
Suchlaufschaltung einen digitalen Zähler 10 umfaßt, dessen
jeweilige Stellung in einem Digitalanalogwandler 11 in
eine proportionale Abstimmung für den Tuner 2 umgewandelt

...

wird. Der Zähler 10 ist über einen Schalter 12 mit
einem Impulsgeber 13 verbunden. Ist der Schalter 12
geschlossen, dann bewirken die Impulse eine Durchstimmung des gesamten Empfangsbereichs des Tuners.
Der Schalter 12 wird beim Empfang eines Senders von
einem Diskriminator 14 geöffnet, nämlich dann, wenn
eine Trägerfrequenz in den Haltebereich der Suchlaufschaltung gelangt.

Der Tuner ist andererseits auf einen bestimmten Sender
einstellbar. Dazu ist der Zähler über einen Wahlschalter
15 mit dem Ausgang eines aus einer Anzahl Speichereinheiten 16, 116, 216 bestehenden Speichers verbindbar, in
denen bestimmte Zählerstellungen abgelegt sind, die jeweils einem Sender zugeordnet sind.

Die bisher beschriebene Empfängerschaltung mit einer digitalen Suchlaufschaltung gehört zum Stand der Technik. Ebenso ist es bekannt, wie die Speichereinheiten zu programmieren
sind; zum Beispiel durch Einlesen der Zählerstellung beim
Empfang eines über die Suchlaufschaltung eingestellten
Senders in den ausgewählten Speicher.

Im Ausführungsbeispiel der Erfindung ist nun an dieser Stelle,
nämlich an jedem Speichereingang, ein Filter 17, 117, 217
vorgesehen. Jedes Filter ist nur bei einer zugeordneten Programmkennung durchlässig, d.h. das Einlesen einer Zählerstellung in einen bestimmten Speicher ist nur dann möglich, wenn der bei dieser Zählerstellung empfangene
Sender die dem Filter zugeordnete Programmkennung ausstrahlt. Die Speichereingänge sind über eine Steuereinheit 18 nacheinander mit dem Leseausgang des Zählers verbindbar.

...

Jedes Filter umfaßt daher einen Speicher 19 für die Sollkennung und eine mit diesem verbundene Vergleichsstufe 20, die andererseits mit dem Kennungsdecoder 8 verbunden ist, und eine Torschaltung 21, die im Eingangskreis des Speichers 16 liegt. Bei Übereinstimmung der Sollkennung mit der vom Kennungsdecoder 8 ermittelten Kennung des gerade empfangenen Senders ist die Torschaltung 21 durchgeschaltet. Somit kann die Stellung des Zählers in den Speicher 16 eingelesen werden, wenn die vorgeschaltete Steuereinheit 18 betätigt wird.

Die Steuereinheit 18 ist zwischen dem Zählerausgang und dem Eingang der Speichereinheit zum Auslösen des Befehls "neu programmieren" eingefügt. Diese Steuereinheit 18 umfaßt einen als Befehlsgeber dienenden Schalter 23, der von dem Gerätebesitzer zu bedienen ist. Dieser Schalter 23 setzt ein umlaufendes Schaltwerk 22 in Be-trieb, das nacheinander die Speichereinheiten 16, 116, 216 aufruft, d.h. mit dem Ausgang des Zählers verbindet. In jeder Stellung des Schaltwerkes wird die Zähler-stellung einmal ausgelesen. Diese Zählerstellung wird jedoch nur in die Speichereinheit eingelesen, wenn dessen zugeordnetes Filter durchgeschaltet ist.

Das hier beschriebene Ausführungsbeispiel kann auf Einrichtungen mit Feldstärkevergleich zwischen verschiedenen Sendern des gleichen Programms, wie sie bereits vorgeschlagen wurden, verzichten; denn der Gerätebenutzer will in der Regel jedes Programm nur mit der, stets gleichbleibenden Taste einschalten. Beim Programmieren läßt der Benutzer zunächst mit der Suchlaufschaltung das gesamte Empfangsspektrum Sender einmal abfragen. Dabei gewinnt er einen Überblick über die Programme, die er empfangen kann. Bei jedem neuen Programm betätigt er einmal den Befehlsgeber. Damit ist dieses Programm automatisch unter der zugeordneten Taste abgelegt.

...

1854

Wird das gleiche Programm auch von einem anderen Sender
übertragen und hält der Gerätebesitzer die Übertragungsqualität bei diesem Sender für besser, dann betätigt er
erneut den Befehlsgeber. Dann wird dieser zweite, demselben Programm zugeordnete Sender in der entsprechenden
Speichereinheit gegen den ersten ausgewechselt. Ist die
Übertragungsqualität schlechter, so wird die Suchlaufschaltung zum Aufsuchen des nächstfolgenden Senders im
Empfangsspektrum wieder eingeschaltet.

— 1 —

ROBERT BOSCH GMBH, 7000 STUTTGART 1

Ansprüche

1. Hör- oder Fernsehrundfunksignalempfänger mit einem automatisch durchstimmbaren Tuner, mit einem dem ZF-Demodulator nachgeschalteten Detektor für im Signal enthaltene Programmkennungen und mit einem Programmtastenfeld, bei dem jeder Taste ein bestimmtes Programm fest zugeordnet ist, dessen Empfangsfrequenz in einem der Taste zugeordneten Speicher abgelegt ist, dessen Inhalt im Bedarfsfall veränderbar ist, dadurch gekennzeichnet, daß jedem Speicher (16, 116, 126) ein Filter (17, 117, 217) vorgeschaltet ist, welches nur bei Empfang der Programmkennung des der Taste zugeordneten Programms zur Neuablage der Empfangsfrequenzen durchlässig wird, daß alle Filter (17, 117, 217) mit einem umlaufenden Schaltwerk (22) verbunden sind, das bei Neuablage einer Empfangsfrequenz diese allen Speichern (16, 116, 216) nacheinander anbietet und daß jedes Filter (17, 117, 217) mit dem Programmkennungsdetektor (8) verbunden ist.

2. Hör- oder Fernsehrundfunksignalempfänger nach Anspruch 1, dadurch gekennzeichnet, daß das Filter (17, 117, 217) einen Speicher (19) für die zugeordnete Sollprogrammkennung und eine Vergleichsstufe (20) umfaßt, die die Sollprogrammkennung mit der am Ausgang des Programmdetektors (8) anstehende Istprogrammkennung vergleicht, und eine von der Vergleichstufe (20) gesteuerte Torschaltung (21) aufweist, die im Eingangskreis des Speichers (16, 116, 216) liegt.

Fig. 1

Fig. 2

Fig. 3